Europäisches Patentamt

European Patent Office

Office européen des brevets

(11) Numéro de publication: **0 353 826 B1**

## (12) FASCICULE DE BREVET EUROPEEN

(45) Date de publication de fascicule du brevet: **03.11.93** (51) Int. Cl.5: **H03M 7/42**

(21) Numéro de dépôt: **89202000.9**

(22) Date de dépôt: **31.07.89**

(54) **Dispositif de codage statistique pour fournir des mots de code comportant un nombre variable d'éléments binaires.**

(30) Priorité: **05.08.88 FR 8810617**

(43) Date de publication de la demande:
**07.02.90 Bulletin 90/06**

(45) Mention de la délivrance du brevet:
**03.11.93 Bulletin 93/44**

(84) Etats contractants désignés:
**BE DE FR GB IT SE**

(56) Documents cités:
**EP-A- 0 098 153**

**IBM TECHNICAL DISCLOSURE BULLETIN, vol. 23, no. 3, août 1980, pages 1211-1216, New York, US; P.F. SMITH: "Serial-by-character data compactor/expander"**

(73) Titulaire: **TELECOMMUNICATIONS RADIOE-LECTRIOUES ET TELEPHONIOUES T.R.T.**
**88, rue Brillat Savarin**
**F-75013 Paris(FR)**
(84) Etats contractants désignés:
**BE DE GB IT SE**

(73) Titulaire: **TRT TELECOMMUNICATIONS RA-DIOELECTRIOUES ET TELEPHONIOUES**
**88 rue Brillat Savarin**
**F-75013 Paris(FR)**
(84) Etats contractants désignés:
**FR**

(72) Inventeur: **Boisson, Jean-Yves Société Civile S.P.I.D.**
**209, rue de l'Université**
**F-75007 Paris(FR)**
Inventeur: **Langlais, Thierry Société Civile S.P.I.D.**
**209, rue de l'Université**
**F-75007 Paris(FR)**
Inventeur: **Moliere, Françoise Société Civile S.P.I.D.**
**209, rue de l'Université**
**F-75007 Paris(FR)**

(74) Mandataire: **Chaffraix, Jean et al**
**Société Civile S.P.I.D.**
**156, Boulevard Haussmann**
**F-75008 Paris (FR)**

## Description

L'invention concerne un dispositif de codage statistique pour fournir des mots de code variables comportant un nombre "n" variable d'éléments binaires (n variant de 1 à N), dispositif muni :
- d'une entrée pour recevoir à un certain rythme l'information à coder sous forme de mots fixes comportant un nombre d'éléments binaires,
- d'un premier organe de transcodage pour fournir ledit mot de code variable sur "n" sorties parmi n sorties en parallèle,
- d'un deuxième organe de transcodage pour fournir à sa sortie l'indication de longueur "n",
- d'un organe d'accumulation, pour former une première information de cumul "modulo N", résultat d'opérations effectuées sur "n",
- de moyens de permutation circulaire pour fournir un mot permuté représentant le mot de code variable permuté en fonction de la première information de cumul,
- de moyens d'aiguillage pour transférer audit rythme sélectivement, en fonction d'une deuxième information de cumul, dans un premier et/ou dans un deuxième registre les éléments binaires du mot permuté, ces deux registres permutant des emplacements allant de 0 à 2N-1,
- de moyens de détection coopérant avec l'organe d'accumulation pour détecter l'état de remplissage de l'un desdits registres pour agir sur des moyens de transfert afin de transférer le contenu du registre rempli vers la sortie.

De tels dispositifs trouvent des applications importantes dans les cas où l'on veut réduire le débit d'information. Par ce codage, on établit une statistique des mots à coder. Les mots qui surviennent le plus souvent sont affectés d'un mot variable de courte longueur et ceux qui surviennent rarement à une grande longueur. Ce mot de codage est particulièrement intéressant dans le domaine de la transmission de signaux pour lesquels on sait extraire des grandeurs statistiques (exemple : paroles, images, textes) car il permet de réduire considérablement le débit sans altérer l'information.

Un problème qui survient pour réaliser ces codeurs dans le domaine de la télévision est la vitesse de traitement ; en effet chaque point doit être codé à une cadence 1/13,5 MHz.

Un tel dispositif est décrit dans la publication IBM Technical Disclosure Bulletin, vol.23, n°3, août 1980, pages 1211 à 1216. Cependant ce dispositif ne donne aucun élément pour réaliser le circuit d'aiguillage, selon les contraintes de vitesse précitées.

La présente invention propose un dispositif tel que mentionné dans le préambule qui permet avec des circuits simples et courants d'obtenir une vitesse de traitement élevée.

Pour cela, un tel dispositif est remarquable en ce que :
- l'organe d'accumulation fournit comme deuxième information de cumul une valeur k en effectuant une addition "modulo 2N", résultat d'opérations effectuées sur "n",
et en ce que les moyens d'aiguillage sont formés :
- par des séries de commutateurs à au moins deux positions affectés chacun à un emplacement desdits registres pour, selon une première position connecter l'entrée de l'emplacement à la sortie des moyens de permutation et pour, selon une deuxième position, interconnecter l'entrée avec la sortie de l'emplacement,
- et par des moyens de commandes, pilotés en fonction de la deuxième information de cumul, pour mettre à la première position N commutateurs affectés respectivement aux emplacements k à k + N modulo 2N et pour mettre à la deuxième position, les autres commutateurs.

La description suivante accompagnée des dessins ci-annexés, le tout donné à titre d'exemple non limitatif fera bien comprendre comment l'invention peut être réalisée.

La figure 1 montre un dispositif de codage conforme à l'invention.

La figure 2 montre un mode de réalisation préférentiel pour combiner l'organe de permutation avec le premier organe de transcodage.

La figure 3 montre le détail de réalisation du circuit d'aiguillage et son interconnexion avec le premier et le deuxième registre.

La figure 4 montre une succession de mot à coder et le résultat attendu.

La figure 5 est un diagramme destiné à faire comprendre comment le dispositif de codage de l'invention fonctionne.

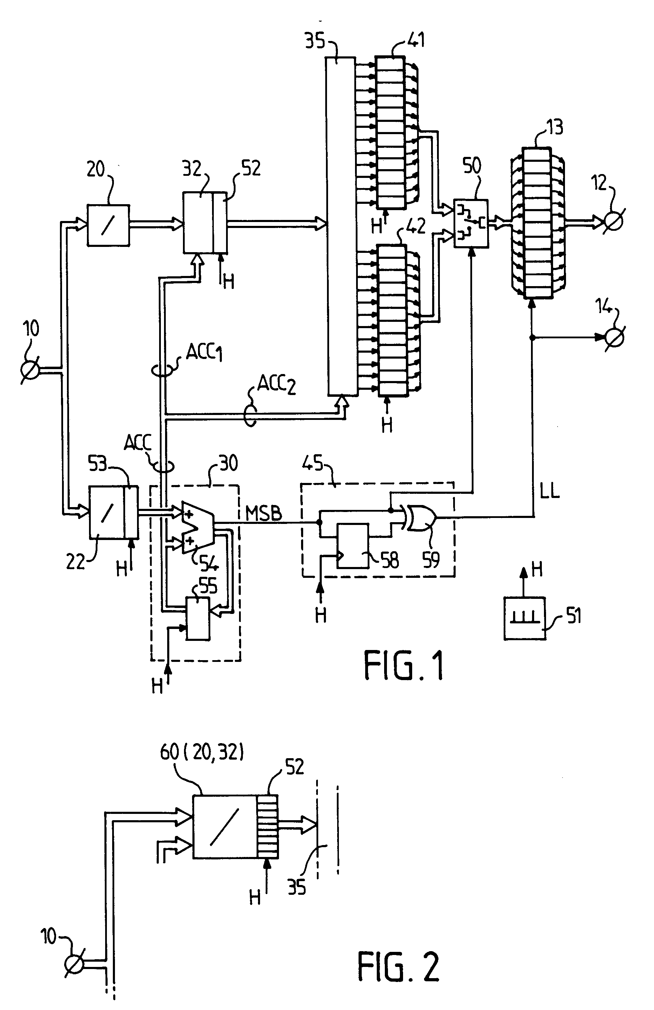

Le dispositif de l'invention montré à la figure 1 comporte une entrée 10 pour recevoir un code d'entrée à convertir. Ce code se présente sous la forme de m éléments binaires en parallèle pour représenter $M = 2^m$ mots d'information, par exemple m = 4 et M = 16. 16 mots d'information W1 à W16 peuvent alors être codés. A chacun de ces mots va correspondre un mot de code statistique dont la longueur peut varier d'un nombre minimum à un nombre N maximal par exemple N = 12. Le tableau I ci-dessous donne ces mots dans la colonne 2 en correspondance avec les mots d'entrée portés dans la colonne 1.

Ces mots variables apparaissent à la sortie 12 d'un registre de sortie 13 accompagnés d'un signal de validation LL apparaissant à la sortie 14.

Le dispositif comporte un premier organe de transcodage 20 qui, à partir des mots d'entrée fournit les mots variables sur certaines de ses douze sorties. Les mots variables débutent toujours sur les premières positions de ces sorties comme l'indique la colonne 3 du tableau I. Sur les autres positions non concernées par le mot statistique on peut avoir indifféremment des "1" ou des "0" ce qui est indiqué par "X" à la colonne 3 du tableau I. Un deuxième organe de transcodage 22 dont l'entrée est connectée, tout comme celle de l'organe 20, à l'entrée 10 fournit un code binaire donnant l'indication de longueur du nombre d'éléments binaires dont est formé le mot variable.

## TABLEAU I

| Colonne 1 | Colonne 2 | Colonne 3 | Colonne 4 |
|---|---|---|---|
| Code d'entrée (en décimal) | Code statistique (en binaire) | Code statistique sur douze bits à la sortie du convertisseur 20 | Code de longueur (en décimal) |
| W8 | 1 | 1XXXXXXXXXXX | 1 |
| W7 | 01 | 01XXXXXXXXXX | 2 |
| W9 | 001 | 001XXXXXXXXX | 3 |
| W6 | 00010 | 00010XXXXXXX | 5 |
| W10 | 000110 | 000110XXXXXX | 6 |
| W11 | 0001110 | 0001110XXXXX | 7 |
| W5 | 00011110 | 00011110XXXX | 8 |
| W4 | 00011111110 | 00011111110X | 11 |
| W12 | 00011111111 | 00011111111X | 11 |
| W13 | 000111111011 | 000111111011 | 12 |
| W3 | 000111111010 | 000111111010 | 12 |
| W14 | 000111111001 | 000111111001 | 12 |
| W2 | 000111111000 | 000111111000 | 12 |
| W15 | 000111110111 | 000111110111 | 12 |
| W1 | 000111110110 | 000111110110 | 12 |
| W16 | 000000111111 | 000000111111 | 12 |

X = 0 ou 1 indifféremment.

Conformément à l'invention, le dispositif comporte :
- à la sortie de l'organe de transcodage 22 un organe d'accumulation 30 pour former une première information de cumul ACC1, résultat du cumul effectué modulo "N" sur les indications de longueur et une deuxième information représentant un ACC2 cumul effectué modulo "2N" cette fois,
- des moyens de permutation circulaires 32 pour fournir un mot permuté représentant le mot de code variable, permuté en fonction de l'information de cumul,
- des moyens d'aiguillage 35 pour transférer sélectivement dans un premier ou dans un deuxième registre 41 et 42 les éléments du mot permuté,

3

- des moyens de détection 45 coopérant avec l'organe accumulateur 30 pour détecter le remplissage du premier ou du deuxième registre pour agir sur des moyens de transfert 50 qui transfère le registre rempli en direction de la sortie 12 en passant par l'intermédiaire du registre 13. Une horloge 51 fournit un signal H qui fixe le rythme de fonctionnement du dispositif. L'horloge H est l'horloge d'entrée des données dans le système, qui impose la cadence de traitement. La fréquence de sortie des données sur le bus de N bits est inférieure ou égale à celle de l'horloge H, ce qui fait le principal intérêt du système. Ce signal H agit sur les commandes de chargement des registres 52 et 53 qui sont couplés aux sorties des organes 32 et 22.

L'organe d'accumulation 30 est formé d'un additionneur 54 qui additionne l'indication de longueur provenant du deuxième organe de transcodage 22 avec le contenu d'un registre d'accumulation 55 dont l'entrée est reliée à la sortie de l'additionneur 54. Les moyens de détection 45 utilisent le signal MSB représentant l'élément binaire de plus fort poids à la sortie de l'additionneur 54. La valeur de MSB détermine la position d'un multiplexeur 50 constituant, en partie, les moyens de transfert. Le transfert entre les registres 41 ou 42 vers le registre de sortie 13 n'est effectif que si le signal LL est élaboré, ce signal agissant sur la commande de chargement du registre 13. Pour élaborer ce signal LL on utilise une bascule de type D 58 qui enregistre à chaque front actif du signal H le signal MSB ; une porte "OU-EXCLUSIF" 59 dont les entrées sont reliées aux entrée et sortie de cette bascule fournit ce signal LL. Ce signal LL est donc actif à chaque changement de la valeur MSB.

L'organe d'accumulation 30 fournit une somme de cumul, ACC1 qui est une somme modulo "N" pour l'organe de permutation 32 et une somme de cumul ACC2 modulo "2N" pour le circuit d'aiguillage 35 ainsi qu'il l'a été dit.

Selon un mode de réalisation préféré les moyens de permutation 32 sont combinés avec l'organe de transcodage 20 de sorte qu'une mémoire morte 60 (voir figure 2) peut être programmée pour effectuer cette combinaison de la manière indiquée par le tableau II. L'ordre de permutation est donnée par une information ACC1 indiquant une permutation s'échelonnant de 1 à 12. Le tableau II donne la correspondance du code à la sortie de la mémoire 60 pour deux valeurs du code d'entrée (5 et 4) et pour des valeurs de PM variant de 1 à M. Il sera alors facile pour l'homme de l'art d'effectuer la programmation de cette mémoire pour toutes valeurs du code d'entrée.

## TABLEAU II

| ACC1 | Code d'entrée W5 | Code d'entrée W4 |
|:---:|:---:|:---:|
| 0 | 00011110XXXX | 00011111110X |
| 1 | X00011110XXX | X00011111110 |
| 2 | XX00011110XX | 0X0001111111 |
| 3 | XXX00011110X | 10X000111111 |
| 4 | XXXX00011110 | 110X00011111 |
| 5 | 0XXXX0001111 | 1110X0001111 |
| 6 | 10XXXX000111 | 11110X000111 |
| 7 | 110XXXX00011 | 111110X00011 |
| 8 | 1110XXXX0001 | 1111110X0001 |
| 9 | 11110XXXX000 | 11111110X000 |
| 10 | 011110XXXX00 | 011111110X00 |
| 11 | 0011110XXXX0 | 0011111110X0 |

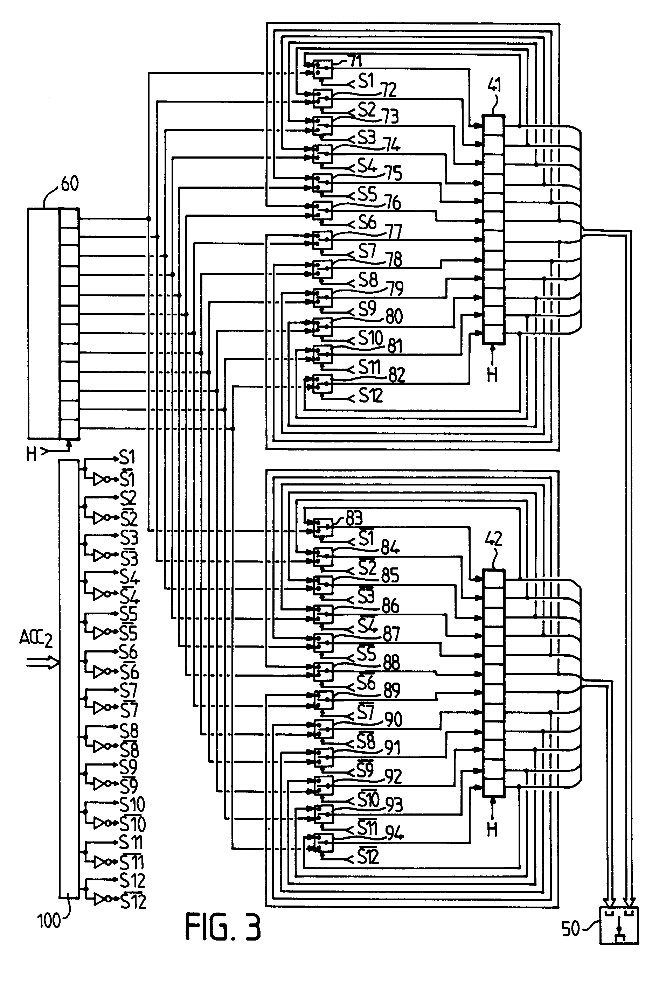

A la figure 3, on a montré en détail le circuit d'aiguillage et son interconnexion avec les registres 41 et 42.

Ce circuit est constitué par une première série de commutateurs à deux entrées 71 à 82 commandés respectivement par des signaux de commande S1 à S12 et une deuxième série 83 à 94 commandée par des signaux $\overline{S1}$ à $\overline{S12}$ complémentaires des précédents. Les sorties des commutateurs 71 à 82 sont connectées respectivement aux entrées-parallèle du regustre 41. Celles des commutateurs 83 à 94, aux entrées-parallèle du registre 42. Les premières entrées des commutateurs 71 à 82 sont reliées respectivement aux sorties-parallèle du registre 41, et les premières entrées des commutateus 83 à 94 aux sorties du registre 42. Les secondes entrées des commutateurs 71 à 94 sont reliées aux sorties de la mémoire morte 60.

Les signaux S1 à S12 et les signaux $\overline{S1}$ à $\overline{S12}$ dérivés des précédents par inversion logique sont engendrés par un circuit de transcodage 100 qui peut être programmé aisément en fonction du tableau III suivant où la valeur "1" pour les signaux S1 à S12 signifie que la seconde entrée est en relation avec la sortie de 60 et que la valeur "0" signifie, par suite de rebouclage de la sortie sur l'entrée, que la valeur de l'élément binaire ne change pas.

**TABLEAU III**

| ACC2 (en décimal) | S1 | S2 | S3 | S4 | S5 | S6 | S7 | S8 | S9 | S10 | S11 | S12 |
|---|---|---|---|---|---|---|---|---|---|---|---|---|
| 0 | 0 | 0 | 0 | 0 | 0 | 0 | 0 | 0 | 0 | 0 | 0 | 0 |
| 1 | 0 | 0 | 0 | 0 | 0 | 0 | 0 | 0 | 0 | 0 | 0 | 1 |
| 2 | 0 | 0 | 0 | 0 | 0 | 0 | 0 | 0 | 0 | 0 | 1 | 1 |
| 3 | 0 | 0 | 0 | 0 | 0 | 0 | 0 | 0 | 0 | 1 | 1 | 1 |
| 4 | 0 | 0 | 0 | 0 | 0 | 0 | 0 | 0 | 1 | 1 | 1 | 1 |
| 5 | 0 | 0 | 0 | 0 | 0 | 0 | 0 | 1 | 1 | 1 | 1 | 1 |
| 6 | 0 | 0 | 0 | 0 | 0 | 0 | 1 | 1 | 1 | 1 | 1 | 1 |
| 7 | 0 | 0 | 0 | 0 | 0 | 1 | 1 | 1 | 1 | 1 | 1 | 1 |
| 8 | 0 | 0 | 0 | 0 | 1 | 1 | 1 | 1 | 1 | 1 | 1 | 1 |
| 9 | 0 | 0 | 0 | 1 | 1 | 1 | 1 | 1 | 1 | 1 | 1 | 1 |
| 10 | 0 | 0 | 1 | 1 | 1 | 1 | 1 | 1 | 1 | 1 | 1 | 1 |
| 11 | 0 | 1 | 1 | 1 | 1 | 1 | 1 | 1 | 1 | 1 | 1 | 1 |
| 12 | 1 | 1 | 1 | 1 | 1 | 1 | 1 | 1 | 1 | 1 | 1 | 1 |
| 13 | 1 | 1 | 1 | 1 | 1 | 1 | 1 | 1 | 1 | 1 | 1 | 0 |
| 14 | 1 | 1 | 1 | 1 | 1 | 1 | 1 | 1 | 1 | 1 | 0 | 0 |
| 15 | 1 | 1 | 1 | 1 | 1 | 1 | 1 | 1 | 1 | 0 | 0 | 0 |
| 16 | 1 | 1 | 1 | 1 | 1 | 1 | 1 | 1 | 0 | 0 | 0 | 0 |
| 17 | 1 | 1 | 1 | 1 | 1 | 1 | 1 | 0 | 0 | 0 | 0 | 0 |
| 18 | 1 | 1 | 1 | 1 | 1 | 1 | 0 | 0 | 0 | 0 | 0 | 0 |
| 19 | 1 | 1 | 1 | 1 | 1 | 0 | 0 | 0 | 0 | 0 | 0 | 0 |
| 20 | 1 | 1 | 1 | 1 | 0 | 0 | 0 | 0 | 0 | 0 | 0 | 0 |
| 21 | 1 | 1 | 1 | 0 | 0 | 0 | 0 | 0 | 0 | 0 | 0 | 0 |
| 22 | 1 | 1 | 0 | 0 | 0 | 0 | 0 | 0 | 0 | 0 | 0 | 0 |
| 23 | 1 | 0 | 0 | 0 | 0 | 0 | 0 | 0 | 0 | 0 | 0 | 0 |

EP 0 353 826 B1

Le dispositif de codage de l'invention fonctionne de la manière suivante.

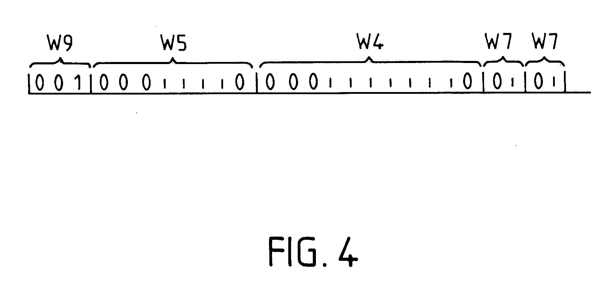

Soient les mots W9, W5, W4, W7, W7,... à coder successivement. La figure 4 montre, en correspondance avec ces mots la succession des éléments binaires qu'ils impliquent.

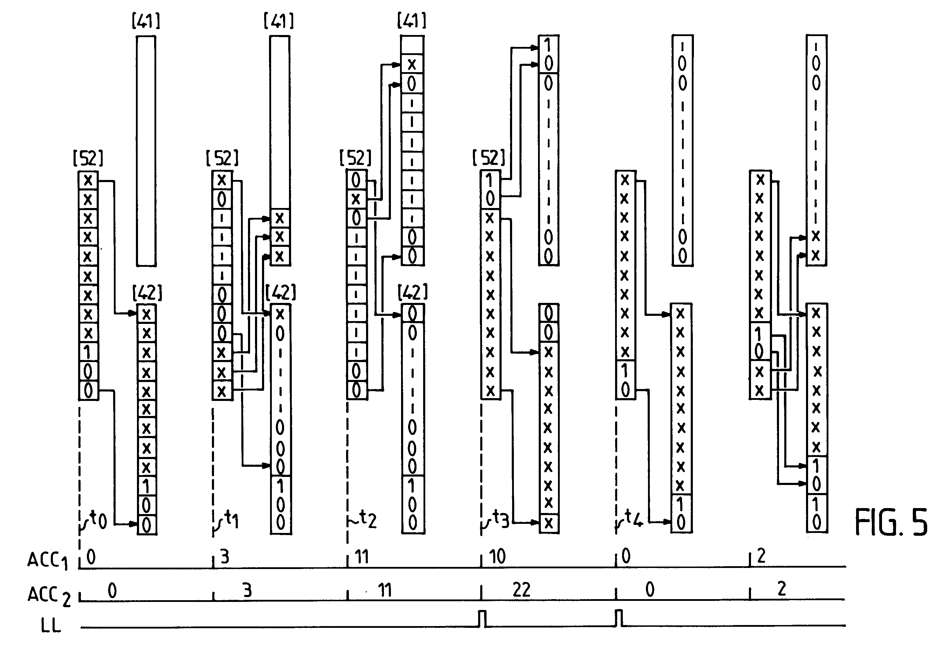

En reference à la figure 5, on admet que le mot W9 apparaît après le codage effectué par la mémoire 60 à l'instant to dans le registre 52, et l'on admet aussi qu'à cet instant les sommes de cumul ACC1 et ACC2 sont égales à "0". Conformément aux tableaux II et III le code statistique n'est pas permuté et tout le contenu de registre 52 est transféré dans le registre 42. A l'instant t1 un nouveau code apparaît dans le registre 52 et le code est permuté par la valeur "3" correspondant à la longueur du code précédent. De ce fait les commutateurs 80, 81 et 82 autorise le transfert des trois premières positions du registre 52 dans les trois premières position du registre 41. Les neuf dernières positions du registre 52 sont transférées dans les neuf dernières positions du registre 42. A l'instant t2, ACC1 et ACC2 prennent les valeurs 11, ce qui entraîne une permutation de 11 fois du mot variable correspondant au mot W4 et du transfert des onze dernières positions du registre 52 dans le registre 41 et de la première position dans la première position du registre 42.

A l'instant t3 le signal MSB a changé de valeur de sorte que les valeurs ACC1 et ACC2 vont différer mais le signal LL devient actif de sorte que le contenu du registre 42 va être transféré dans le registre de sortie 13. A l'instant t4 on aura aussi un changement de valeur de MSB qui produit aussi un signal actif de LL.

## Revendications

1. Dispositif de codage statistique pour fournir des mots de code variables comportant un nombre "n" variable d'éléments binaires (n variant de 1 à N), dispositif muni :
   - d'une entrée (10) pour recevoir à un certain rythme l'information à coder sous forme de mots fixes comportant un nombre d'éléments binaires,
   - d'un premier organe de transcodage (20) pour fournir ledit mot de code variable sur "n" sorties parmi n sorties en parallèle,
   - d'un deuxième organe de transcodage (22) pour fournir à sa sortie l'indication de longueur "n",
   - d'un organe d'accumulation (30), pour former une première information de cumul "modulo N" (ACC1), résultat d'opérations effectuées sur "n",
   - de moyens de permutation circulaire (32) pour fournir un mot permuté représentant le mot de code variable permuté en fonction de la première information de cumul,
   - de moyens d'aiguillage (35) pour transférer audit rythme sélectivement, en fonction d'une deuxième information de cumul (ACC2), dans un premier et/ou dans un deuxième registre (41, 42) les éléments binaires du mot permuté, ces deux registres permutant des emplacements allant de 0 à 2N-1,
   - de moyens de détection (45) coopérant avec l'organe d'accumulation pour détecter l'état de remplissage de l'un desdits registres pour agir sur des moyens de transfert (50, 13) afin de transférer le contenu du registre rempli vers la sortie,
   caractérisé en ce que :
   - l'organe d'accumulation (30) fournit comme deuxième information de cumul une valeur k en effectuant une addition, "modulo 2N", résultat d'opérations effectuées sur "n",
   et en ce que les moyens d'aiguillage sont formés :
   - par des séries de commutateurs à au moins deux positions (71...82) affectés chacun à un emplacement desdits registres pour, selon une première position connecter l'entrée de l'emplacement à la sortie des moyens de permutation (32) et pour, selon une deuxième position, interconnecter l'entrée avec la sortie de l'emplacement,
   - et par des moyens de commandes (100), pilotés en fonction de la deuxième information de cumul, pour mettre à la première position N commutateurs affectés respectivement aux emplacements k à k + N modulo 2N et pour mettre à la deuxième position, les autres commutateurs.

## Claims

1. A statistic coding arrangement for producing variable length code words comprising a variable number "n" of bits (n varying from 1 to N), the arrangement comprising:
   - a input (10) for receiving, in a given rhythm, the information to be encoded as fixed words comprising a number of bits,

6

- a first transcoding member (20) for applying said variable length code word to "n" outputs among n parallel outputs,
- a second transcoding member (22) for supplying the indication of the length "n" from its output,
- an accumulation member (30) for forming a first "modulo N" accumulated information (ACC1), resulting from operations performed on "n",
- cyclic permutation means (32) for producing a permuted word which represents the permuted variable length code word as a function of the first accumulated information,
- routing means (35) for selectively transferring in said rhythm, as a function of a second accumulated information (ACC2), the bits of the permuted word to a first and/or a second register (41, 42), these two registers permuting bit locations ranging between 0 ad 2N-1,
- detection means (45) cooperating with the accumulation member for detecting the filling level of one of said registers to act on the transfer means (50, 13) so as to transfer the contents of the filled register to the output,

characterized in that:
- the accumulation member (30) provides a value k as the second accumulated information by realizing a "modulo 2N" addition, resulting from operations performed on "n",

and in that the routing means are constituted by:
- series of switches having at least two positions (71...82) each assigned to a bit location of said registers for connecting, in accordance with a first position, the input of the bit location to the output of the permutation means (32), and for interconnecting, in accordance with a second position, the input to the output of the bit location,
- and by control means (100), controlled as a function of the second accumulated information, for setting N switches assigned to bit locations k to (k + N) modulo 2N, respectively, in the first position and for setting the other switches in the second position.

## Patentansprüche

1. Statistische Codierungsvorrichtung zur Erzeugung variabler Codewörter mit einer variablen Anzahl von "n" Binärelementen (wobei n von 1 bis N variiert), wobei diese Vorrichtung die nachfolgenden Elemente aufweist:
    - einen Eingang (10) zum in einem bestimmten Rhythmus Empfangen der zu codierenden Information als feste Wörter mit einer Anzahl von Binärelementen,
    - ein erstes Transcodierungselement (20) zum Zuführen des genannten Codewortes variabler Länge zu "n" Ausgängen von n parallelen Ausgängen,
    - ein zweites Transcodierungselement (22) zum an seinem Ausgang Liefern der Längenanzeige "n",
    - ein Akkumulationselement (30) zum Bilden einer ersten "Modulo-N"-akkumulierten Information (ACC1) als Ergebnis aus den mit "n" durchgeführten Vorgängen,
    - Mittel zur zyklischen Verschiebung (32) zum Erzeugen eines verschobenen Wortes, das das Codewort verschobener variabler Länge als Funktion der ersten akkumulierten Information darstellt,
    - Weichenmittel (35) zur selektiven Übertragung in dem genannten Rhythmus als Funktion einer zweiten akkumulierten Information (ACC2) der Binärelemente des verschobenen Wortes in ein erstes und/oder zweites Register (41, 42), wobei diese Register Bitstellen zwischen 0 und 2N-1 verschieben,
    - Detektionsmittel (45), die mit dem Akkumulationselement zusammenarbeitet zum Detektieren des Füllpegels eines der genannten Register zur Beeinflussung der Übertragungsmittel (50, 13) zum Übertragen des Inhaltes des gefüllten Registers zum Ausgang,

dadurch gekennzeichnet, daß
    - das Akkumulationselement (30) als zweite akkumulierte Information einen Vektor K liefert, indem eine "Modulo 2N"-Addierung durchgeführt wird als Ergebnis der mit "n" durchgeführten Vorgänge,

und daß die Verschiebungsmittel durch die nachfolgenden Elemente gebildet werden:
    - Reihen von Schaltern mit mindestens zwei Stellungen (71....82), die je einer Bitstelle der genannten Register zugeordnet sind zum entsprechend einer ersten Position Verbinden des Eingangs der Bitstelle mit dem Ausgang der Verschiebungsmittel (32), und zum entsprechend einer zweiten Position Verbinden des Eingangs mit dem Ausgang der Bitstelle,

- und Steuermittel (100), die als Funktion der zweiten akkumulierten Information gesteuert werden zum Stellen von N Bitstellen k bis (k + N) Modulo 2N zugeordneten Schaltern in die erste Stellung bzw. zum Stellen der anderen Schalter in die zweite Stellung.

FIG.1

FIG.2

FIG. 3

W9    W5              W4         W7  W7

|0 0 1|0 0 0 ı ı ı ı 0|0 0 0 ı ı ı ı ı ı ı 0|0 ı|0 ı|

# FIG. 4

FIG. 5